# EUROPEAN PATENT APPLICATION

(11) **EP 4 741 740 A2**
(43) Date of publication of application: **13.05.2026**
(21) Application number: 25213797.1
(22) Date of filing: 05.11.2025
(51) Int. Cl.: F25B 49/02

(54) **HYDRONIC FREE COOLING CHILLER WITH SUBCOOLING**

(30) Priority: 06.11.2024 US 202463716973 P; 08.09.2025 US 202563877429 P
(71) Applicant: Carrier Corporation, Palm Beach Gardens, FL 33418 (US)
(72) Inventor: GRABON, Michel, 01120 Montluel (FR); GUY, Alexis, 01120 Montluel (FR)
(74) Representative: Dehns

(57) **Abstract**

A cooling system (20) includes a refrigeration circuit (22) and a coolant circuit (40) for cooling a working fluid to meet a cooling demand. The coolant circuit (40) is thermally coupled to the refrigeration circuit (22). A free cooling circuit (50) is in selective thermal communication with the refrigeration circuit (22) and is in selective thermal communication with the coolant circuit (40).

## Description

### BACKGROUND

Exemplary embodiments pertain to cooling systems, and more particularly, to a cooling system capable of performing free cooling.

Cooling systems are known for various purposes, such as for cooling of data centers. Such cooling systems can use one or more refrigeration circuits to provide mechanical cooling. It has also been known to supplement or replace mechanical cooling with free cooling, e.g., by cooling of a coolant fluid in heat exchange with outside air. Some systems use a separate free cooling circuit with a low temperature coolant fluid such as glycol, which then exchanges heat with a water circuit that is used for providing cooling within a building, e.g., for a data center. The coils of the free cooling circuit may be arranged directly adjacent to the coils used when a cooling system is operated in a mechanical mode. The coils used to perform free cooling are not activated when the system is operating in the mechanical mode. As a result, the coils used to perform the free cooling create an air side resistance that impacts unit efficiency and capacity when operating in the mechanical mode.

### BRIEF DESCRIPTION

According to a first aspect of the invention a cooling system is provided, the cooling system includes a refrigeration circuit and a coolant circuit for cooling a working fluid to meet a cooling demand. The coolant circuit is thermally coupled to the refrigeration circuit. A free cooling circuit is in selective thermal communication with the refrigeration circuit and is in selective thermal communication with the coolant circuit.

Optionally, the refrigeration circuit includes a heat rejection heat exchanger and the free cooling circuit includes a first heat exchanger positioned directly adjacent to the heat rejection heat exchanger.

Optionally, the cooling system comprises a fan operable to move a flow of air across the first heat exchanger and the heat rejection heat exchanger in series. The first heat exchanger may be upstream from the heat rejection heat exchanger relative to the flow of air.

Optionally, the free cooling circuit includes a subcooler heat exchanger and the free cooling circuit is thermally coupled to the refrigeration circuit at the subcooler heat exchanger.

Optionally, the first heat exchanger and the subcooler heat exchanger are arranged in series relative to a flow of free cooling fluid within the free cooling circuit.

Optionally, the subcooler heat exchanger is arranged downstream from the heat rejection heat exchanger relative to a flow of refrigerant circulating through the refrigeration circuit.

Optionally, the free cooling circuit includes a main return conduit and a first free cooling bypass conduit arranged in parallel, the first free cooling bypass conduit being fluidly connected to an inlet of the subcooler heat exchanger.

Optionally, the cooling system comprises: a second free cooling bypass conduit fluidly connecting an outlet of the subcooler heat exchanger to the main return conduit, a valve disposed within the main return conduit, and another valve disposed within the second free cooling bypass conduit.

Optionally, the inlet of the first free cooling bypass conduit is fluidly connected to the main return conduit upstream from the valve and the outlet of the second free cooling bypass conduit is fluidly connected to the main return conduit downstream from the valve.

Optionally, the free cooling circuit includes a second heat exchanger and the free cooling circuit is thermally coupled to the coolant circuit at the second heat exchanger.

According to a second aspect of the invention a cooling system is provided, the cooling system includes a refrigeration circuit and a coolant circuit thermally coupled to the refrigeration circuit. A free cooling circuit is arranged in selective fluid communication with the coolant circuit and is arranged in selective thermal communication with the refrigeration circuit.

Optionally, the refrigeration circuit includes a heat absorbing heat exchanger and the coolant circuit is thermally coupled the refrigeration circuit at the heat absorbing heat exchanger.

Optionally, both an inlet of the free cooling circuit and an outlet of the free cooling circuit are fluidly connected to the coolant circuit upstream from the heat absorbing heat exchanger.

Optionally, at least one valve is operable to control a flow of fluid from the coolant circuit to the free cooling circuit.

Optionally, the refrigeration circuit includes a heat rejecting heat exchanger and the free cooling circuit includes a first heat exchanger positioned directly adjacent to the heat rejecting heat exchanger. The first heat exchanger is arranged in series with the heat rejecting heat exchanger relative to an air flow.

Optionally, the free cooling circuit includes a subcooler heat exchanger and the free cooling circuit is thermally coupled the refrigeration circuit at the subcooler heat exchanger. The first heat exchanger and the subcooler heat exchanger may be arranged in series relative to a flow of fluid within the free cooling circuit.

Optionally, the free cooling circuit includes a first free cooling bypass conduit extending between and fluidly connecting an outlet of the first heat exchanger and an inlet of the subcooler heat exchanger.

Optionally, the free cooling circuit includes a second free cooling bypass conduit extending between and fluidly connecting an outlet of the subcooler heat exchanger and an inlet of the first heat exchanger.

Optionally, the free cooling circuit includes at least one valve operable to fluidly separate the free cooling circuit from the coolant circuit. When the free cooling circuit is fluidly separate from the coolant circuit, the flow of fluid at the outlet of the subcooler heat exchanger may be returned directly to the inlet of the first heat exchanger via the second free cooling bypass conduit.

Optionally, the free cooling circuit includes an auxiliary pump operable to circulate the fluid between the first heat exchanger and the subcooler heat exchanger.

Optionally, the at least one valve is located downstream from the outlet of the subcooler heat exchanger.

According to an further aspect, a method of operating a cooling system includes providing a coolant circuit for cooling a working fluid to meet a cooling demand, a refrigeration circuit selectively thermally coupled to the coolant circuit, and a free cooling circuit selectively thermally coupled to at least one of the coolant circuit and the refrigeration circuit. The method includes directly transferring heat from the refrigeration circuit to the free cooling circuit during at least one mode of operation of the cooling system.

Optionally, the method comprises at least one of the refrigeration circuit is used to cool the working fluid when an ambient temperature is greater than a temperature of the working fluid at an inlet of the coolant circuit and the free cooling circuit is used to cool the working fluid when the ambient temperature is less than the temperature of the working fluid at the inlet of the coolant circuit.

Optionally, the method comprises at least one of bypassing an interface between the coolant circuit and the free cooling circuit when the refrigeration circuit is operational, moving the working fluid between the coolant circuit and the free cooling circuit in series when the refrigeration circuit is operational, and cooling a fluid of the free cooling circuit directly upstream from a thermal interface between the refrigeration circuit and the free cooling circuit.

### BRIEF DESCRIPTION OF THE DRAWINGS

Certain exemplary embodiments will now be described in greater detail by way of example only and with reference to the accompanying drawings in which:
FIG. 1 is a schematic diagram of a cooling system in a first mode;
FIG. 2 is a schematic diagram of the cooling system of FIG. 1 in a second mode;
FIG. 3 is a schematic diagram of the cooling system of FIG. 1 in a third mode;
FIG. 4 is a schematic diagram of another cooling system;
FIG. 5 is a schematic diagram of the cooling system of FIG. 4 having a refrigeration circuit thermally coupled to the free cooling circuit;
FIG. 6 is a schematic diagram of a cooling system;
FIG. 7 is a schematic diagram of the cooling system of FIG. 6 when no fluid flows from the coolant circuit to the free cooling circuit;
FIG. 8 is a schematic diagram of a cooling system in a first mode;
FIG. 9 is a schematic diagram of the cooling system of FIG. 8 in a second mode;
FIG. 10 is a schematic diagram of the cooling system of FIG. 8 in a third mode; and
FIG. 11 is a schematic diagram of a cooling system of FIG. 8.

### DETAILED DESCRIPTION

A detailed description of one or more embodiments of the disclosed apparatus and method are presented herein by way of exemplification and not limitation with reference to the Figures.

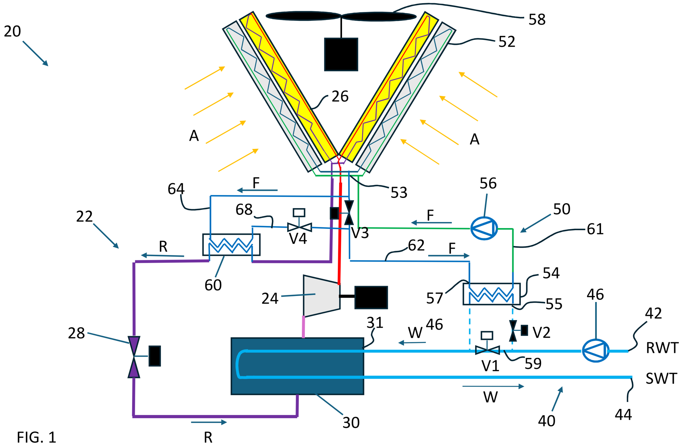

Referring now to FIGS. 1-3, an example of a cooling system 20 is illustrated. The cooling system 20 may be an air handling unit and includes a refrigeration circuit 22 having a closed loop configuration through which a fluid, such as refrigerant R, circulates. As shown, the refrigeration circuit 22 includes a compressor 24, at least one heat rejection heat exchanger or condenser 26, an expansion device 28, and at least one heat absorbing heat exchanger or evaporator 30.

The cooling system 20 additionally includes a coolant circuit 40 operable to cool a working fluid W to meet a cooling demand. The coolant circuit 40 receives a hot working fluid W from an inlet, illustrated generally at 42 and provides a cooler working fluid W to an outlet, illustrated generally at 44. As shown, the coolant circuit 40 may include a pump 46 operable to circulate the working fluid W through the coolant circuit 40. In an embodiment, the working fluid W of the coolant circuit 40 may be water or a water-based fluid. The coolant circuit 40 may be thermally coupled to the refrigeration circuit 22. In an embodiment, the working fluid W of the coolant circuit 40 is arranged in a heat transfer relationship with the refrigerant R of the refrigeration circuit 22 at the heat absorbing heat exchanger 30. For example, heat may be transferred from the working fluid W to the refrigerant R at the heat absorbing heat exchanger 30 such that the working fluid W is cooled at the heat absorbing heat exchanger 30.

The cooling system 20 may further include a free cooling circuit 50. In the illustrated, non-limiting embodiment, the free cooling circuit 50 includes a first heat exchanger 52, a second heat exchanger 54, and a pump 56 for circulating a free cooling fluid F between the first heat exchanger 52 and the second heat exchanger 54. In the illustrated, non-limiting embodiment, a main inlet conduit 61 extends between and fluidly connecting the outlet of the second heat exchanger 54 with the inlet of the first, first heat exchanger 52. Similarly, the free cooling circuit 50 includes a main return conduit 62 extending between and fluidly connecting the outlet 53 of the first heat exchanger 52 to the inlet of the second heat exchanger 54.

In an embodiment, the first heat exchanger 52 is operable as a heat rejecting heat exchanger, the second heat exchanger 54 is operable as a heat absorbing heat exchanger. The first heat exchanger 52 may be positioned adjacent to the heat rejecting heat exchanger 26 of the refrigeration circuit 22. As shown, a fan 58 may be used to move an air flow A across the first heat exchanger 52 of the free cooling circuit 50 and the heat rejecting heat exchanger 26 of the refrigeration circuit 22 in series. In an embodiment, the first heat exchanger 52 of the free cooling circuit 50 is located upstream from the heat rejecting heat exchanger 26 of the refrigeration circuit 22 relative to the movement of the air flow A. The free cooling circuit 50 may be thermally coupled to the coolant circuit 40 at the second heat exchanger 54. The free cooling fluid acts as a heat sink within the second heat exchanger 54. Accordingly, the working fluid W may be cooled by the free cooling fluid F at the second heat exchanger 54.

In the illustrated, non-limiting embodiment, the coolant circuit 40 includes one or more valves operable to control the flow of the working fluid W within the coolant circuit 40 to selectively couple the coolant circuit 40 to the free cooling circuit 50 at the second heat exchanger 54. The coolant circuit 40 may include a bypass conduit 59 arranged in parallel with the second heat exchanger 54 relative to the flow of working fluid W. A first valve V1 may be operable to control the flow of working fluid W provided directly to the heat absorbing heat exchanger 30 through the bypass conduit 59 and a second valve V2 may be associated with an inlet 55 of the second heat exchanger 54. When the first valve V1 is closed and the second valve V2 is open, all of the working fluid W is provided to the second heat exchanger 54 and the heat absorbing heat exchanger 30 of the refrigeration circuit 22 in series. When the first valve V1 is at least partially open, a portion of the flow of working fluid W bypasses the second heat exchanger 54 and is provided directly to the heat absorbing heat exchanger 30 of the refrigeration circuit 22. In such embodiments, the second valve V2 may be open, closed, or at any position therebetween. In instances where working fluid is provided to both the second heat exchanger 54 and the bypass conduit 59 in parallel, the flow of working fluid W output from the second heat exchanger 54 may be mixed with the flow of working fluid W output from the bypass conduit 59 at a location upstream from an inlet 31 of the heat absorbing heat exchanger 30 of the refrigeration circuit 22.

In the illustrated, non-limiting embodiment, the refrigeration circuit 22 additionally includes a subcooler heat exchanger 60 located directly downstream from the heat rejection heat exchanger 26 relative to the flow of refrigerant R. In an embodiment, the subcooler heat exchanger is a fluid-refrigerant heat exchanger. As shown, the subcooler heat exchanger 60 may be thermally coupled to the free cooling circuit 50, such as at a location downstream from the first heat exchanger 52 for example. In the illustrated, non-limiting embodiment, the free cooling circuit 50 includes one or more valves operable to control the flow of the free cooling fluid F within the free cooling circuit 50 to selectively couple the free cooling circuit 50 to the refrigeration circuit 22. For example, a valve V3 may be disposed along a main return conduit 62 extending between and directly fluidly connecting an outlet 53 of the first heat exchanger 52 and an inlet 57 of the second heat exchanger 54.

The free cooling circuit may include one or more bypass conduits. In one or more embodiments, the free cooling circuit 50 includes a first free cooling bypass conduit 64. The first free cooling bypass conduit 64 may fluidly connect an inlet of the subcooler heat exchanger 60 to the main return conduit 62, such as at a location directly downstream from the outlet 53 of the first heat exchanger 52.

A second free cooling bypass conduit 68 extending from an outlet of the subcooler heat exchanger 60 may fluidly connect the outlet of the subcooler heat exchanger 60 with the main inlet conduit 61 at a location downstream from the valve V3, and upstream from the inlet 57 of the second heat exchanger 54. Another valve V4 may be operable to control a flow of free cooling fluid F through the second free cooling bypass conduit 68. Although the valve V4 is illustrated at a position downstream from the subcooler heat exchanger 60 relative to the flow of free cooling fluid F, embodiments where the valve V4 is alternatively arranged at a location within the first free cooling bypass conduit 64 and upstream from the subcooler heat exchanger 60 are also contemplated herein.

When valve V3 is open and valve V4 is closed, the cool free cooling fluid F provided at the outlet 53 of the first heat exchanger 52 is returned directly to the second heat exchanger 54 of the free cooling circuit 50. However, when the valve V4 is at least partially open, some or all of the free cooling fluid F is provided to the first heat exchanger 52 and the subcooler heat exchanger 60 in series. In such embodiments, heat is transferred from the refrigerant R within the refrigeration circuit 22 to the free cooling fluid F at the subcooler heat exchanger 60. In instances where a first portion of the free cooling fluid F bypasses the subcooler heat exchanger 60 via main return conduit 62, and a second portion of the free cooling fluid F is provided in parallel to the subcooler heat exchanger 60, the flow of free cooling fluid F output from the subcooler heat exchanger 60 may be mixed with the flow of working fluid W within the main return conduit 62 at a location upstream from an inlet 57 of the second heat exchanger 54.

In an embodiment, the cooling system 20 includes a controller, illustrated schematically at C. The controller C may include a processor (not shown) operable to control operation of the cooling system 20. Further, in some embodiments, the controller includes a memory (not shown) that may store a computer program executable by the processor, reference data, sensor data, etc. The memory may be implemented using known devices, such as random access memory. The controller is operably coupled to one or more components of the cooling system 20. For example, the controller may be operably coupled to the compressor 24 of the refrigeration circuit 22, to the pump 46 of the coolant circuit 40, to the one or move valves V1, V2 of the coolant circuit 40, to the pump 56 of the free cooling circuit 50 and/or to the one or more valves V3, V4 of the free cooling circuit 50.

It will be appreciated that the option for free cooling via the free cooling circuit 50 and/or mechanical cooling via the refrigeration circuit 22 means that the cooling system 20 is operable in a plurality of different modes. In an embodiment, the cooling system is operable in a first mode, a second mode, and a third mode. In the first mode (FIG. 1), also referred to herein as a mechanical cooling mode, the working fluid W within the coolant circuit 40 is cooled solely by direct heat exchange with the refrigerant R at the heat absorbing heat exchanger 30. In such embodiments, valve V1 may be open and valve V2 may be closed such that all of the working fluid W bypasses the second heat exchanger 54. In some embodiments, in the mechanical cooling mode, the free cooling circuit 50 may also be operational. In such embodiments, the valves of the free cooling circuit 50 may be positioned, for example valve V3 may be closed and valve V4 may be open, such that the free cooling fluid F may flow through the heat exchanger 52, the subcooler heat exchanger 60, and the second heat exchanger 54 in series. In such an embodiment, the heat exchanger 52 of the free cooling circuit 50 provides significant subcooling to the liquid refrigerant within the subcooler heat exchanger 60.

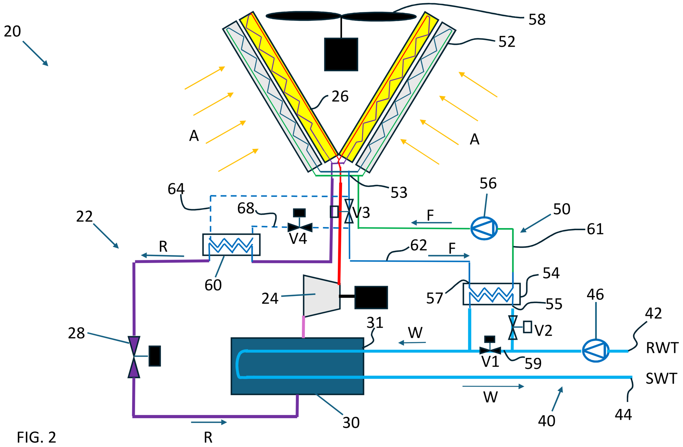

With reference to FIG. 2, in the second mode, also referred to herein as a free-cooling mode, the working fluid W within the coolant circuit 40 is cooled solely by direct heat exchange with the free cooling fluid F at the second heat exchanger 54. Accordingly, valve V2 is open. In the second mode, the compressor 24 of the refrigeration circuit 22 may be non-operational. As a result, no heat transfer occurs between the working fluid W and the refrigerant R at the heat absorbing heat exchanger 30. In the second mode, because the refrigeration circuit 22 is not used to cool the working fluid W, valve V4 may be closed so that the free cooling fluid F bypasses the subcooler heat exchanger 60.

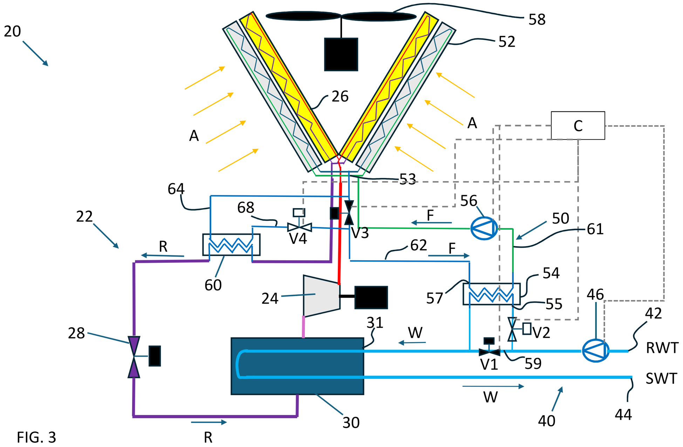

As shown in FIG. 3, in the third mode, also referred to herein as a mixed mechanical and free cooling mode, the working fluid W within the coolant circuit 40 is cooled by both the second heat exchanger 54 of the free cooling circuit 50 and the heat absorbing heat exchanger 30 of the refrigeration circuit 22. In the third mode, refrigerant R is flowing within the refrigeration circuit 22 and the free cooling fluid F is flowing through the free cooling circuit 50. In the third mode, the free cooling fluid is pumped to the first heat exchanger 52, where the free cooling fluid F is cooled. From the first heat exchanger 52, the free cooling fluid F is provided to the subcooler heat exchanger 60 where the free cooling fluid F absorbs heat from the refrigerant R. The heated free cooling fluid F is then provided to the second heat exchanger 54, where the free cooling fluid F absorbs further heat from the working fluid W.

The controller C may be configured to switch the cooling system 20 between the plurality of modes. In an embodiment, the controller C operates the cooling system 20 in the first, mechanical cooling mode (FIG. 1) when the temperature of the ambient air surrounding the heat rejection heat exchanger 26 (also referred to herein as ambient temperature) is greater than the temperature of the working fluid W at the inlet 42 or directly upstream from the second heat exchanger 54 and/or the bypass conduit 59. In an embodiment, the cooling system 20 is operable in the free cooling mode (FIG. 2) when the temperature of the ambient air surrounding the heat rejection heat exchanger 26 and the first heat exchanger 52 is less than the temperature of the working fluid W at the inlet 42 or directly upstream from the second heat exchanger 54 and/or the bypass conduit 59. In embodiments where free cooling via the free cooling circuit 50 is not sufficient to meet the cooling demand of working fluid W, mechanical cooling may be used alternatively to or in addition to the free cooling by activating the refrigeration circuit 22.

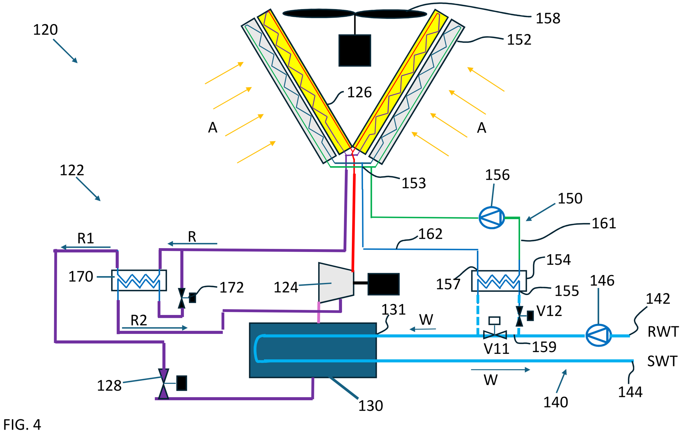

Another embodiment of a cooling system 120 is illustrated in FIG. 4. Similar to FIGS. 1-3, the cooling system includes a refrigeration circuit 122 having a closed loop configuration through which a fluid, such as refrigerant R, circulates. The refrigeration circuit 122 includes a compressor 124, at least one heat rejection heat exchanger or condenser 126, an expansion device 128, and at least one heat absorbing heat exchanger or evaporator 130.

In the illustrated, non-limiting embodiment, the refrigeration circuit 122 includes an economizer heat exchanger 170 located downstream from the heat rejecting heat exchanger 126 relative to the flow of refrigerant within the refrigeration circuit 122. As shown, two flows of refrigerant are provided to the economizer heat exchanger 170. The flow path of the refrigerant circuit may be separated directly upstream from the economizer heat exchanger 170 into a first portion of the refrigerant R1 and a second portion of the refrigerant R2, the first and second portions R1, R2 being arranged in parallel. The first portion of the refrigerant R1 flows through a first pass of the economizer heat exchanger 170. The second portion of the refrigerant R2 is provided to an economizer expansion device 172 and then to a second pass of the economizer heat exchanger 170. Within the economizer heat exchanger 170, the second portion of the refrigerant R2 absorbs heat from the first portion of the refrigerant R1. The further cooled first portion of the refrigerant R1 is provided to the downstream expansion device 128 and the heated second portion of the refrigerant R2 output from the second pass of the economizer heat exchanger 170 is provided to an intermediate or economizer inlet of the compressor 124.

As in the previous embodiment, the cooling system 120 additionally includes a coolant circuit 140 operable to cool the working fluid W to meet a cooling demand. The coolant circuit 140 receives a hot working fluid W from an inlet 142 and provides cooler working fluid W to an outlet 144. The coolant circuit 140 may include a pump 146 operable to circulate the working fluid W through the coolant circuit 140. As shown, the working fluid W of the coolant circuit 140 may be thermally coupled to the refrigerant R of the refrigeration circuit 122 at the heat absorbing heat exchanger 130. For example, heat may be transferred from the working fluid W to the refrigerant R at the heat absorbing heat exchanger 130 such that the refrigerant is vaporized and the working fluid W is cooled at the heat absorbing heat exchanger 130.

A free cooling circuit 150 of the cooling system 120 includes a first heat exchanger 152, a second heat exchanger 154, and a pump 156 for circulating a free cooling fluid F between the first heat exchanger 152 and the second heat exchanger 154. In the illustrated, non-limiting embodiment, a main inlet conduit 161 extends between and fluidly connecting the outlet of the second heat exchanger 154 with the inlet of the first heat exchanger 152. Similarly, the free cooling circuit 150 includes a main return conduit 162 extending between and fluidly connecting the outlet 153 of the first heat exchanger 152 to the inlet of the second heat exchanger 154.

In an embodiment, the first heat exchanger 152 is operable as a heat rejecting heat exchanger and the second heat exchanger 154 is operable as a heat absorbing heat exchanger. The first heat exchanger 152 may be positioned directly adjacent to the heat rejecting heat exchanger 126 of the refrigeration circuit 122. Further, a fan 158 may be used to move an air flow A across the first heat exchanger 152 and the heat rejecting heat exchanger 126 in series. Although the first heat exchanger 152 of the free cooling circuit 150 is located upstream from the heat rejecting heat exchanger 126 relative to the movement of the air flow A, embodiments where the first heat exchanger 152 is located downstream from or in parallel with the heat rejecting heat exchanger 126 relative to the air flow A are also contemplated herein. In the illustrated, non-limiting embodiment, the free cooling circuit 150 may be thermally coupled to the coolant circuit 140 at the second heat exchanger 154. The free cooling fluid F acts as a heat sink and absorbs heat from the working fluid W at the second heat exchanger 154.

As previously described, the coolant circuit 140 may include a first valve V11 operable to control the flow of working fluid W to the heat absorbing heat exchanger 130 by controlling the flow through a bypass conduit 159 arranged in parallel with an inlet 155 of the second heat exchanger 154. The coolant circuit 140 may additionally include a second valve V12 operable to control a flow of working fluid W provided to the inlet 155 of the second heat exchanger 154. It should be appreciated that the valves illustrated and described herein are intended as an example only and that any suitable configured of valves is within the scope of the disclosure.

It will be appreciated that the option for free cooling via the free cooling circuit 150 and/or mechanical cooling via the refrigeration circuit 122 means that the cooling system 120 is operable in a plurality of different modes. In an embodiment, the cooling system 120 is operable in a first mode, a second mode, and a third mode. In the first, mechanical cooling mode, the working fluid W within the coolant circuit 140 is cooled solely by the refrigeration circuit 122, such as via direct heat exchange with the refrigerant R at the heat absorbing heat exchanger 130. In such embodiments, valve V1 may be open and valve V2 may be closed such that all of the working fluid W bypasses the second heat exchanger 154. In the second, free-cooling mode, the working fluid W within the coolant circuit 140 is cooled solely by direct heat exchange with the free cooling fluid F at the second heat exchanger 154. Accordingly, valve V2 is open. In the second mode, the compressor 124 of the refrigeration circuit 122 may be non-operational such that no heat transfer occurs between the working fluid W and the refrigerant R at the heat absorbing heat exchanger 130.

In the third, mixed mechanical and free cooling mode, the working fluid W within the coolant circuit 140 is cooled at both the second heat exchanger 154 of the free cooling circuit 150 and the heat absorbing heat exchanger 130 of the refrigeration circuit 122. In the third mode, refrigerant R is flowing within the refrigeration circuit 122 and the free cooling fluid F is flowing through the free cooling circuit 150. In the third mode, the free cooling fluid is pumped to the first heat exchanger 152, where the free cooling fluid F is cooled before returning to the second heat exchanger 154 to absorbs heat from the working fluid W.

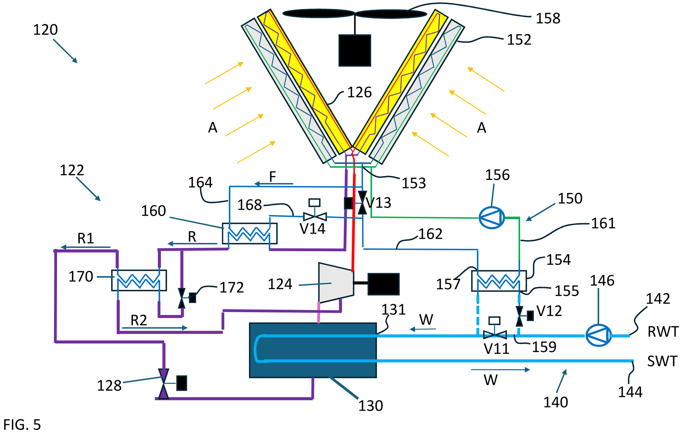

The cooling system of FIG. 5 is substantially similar to that of FIG. 4. However, in FIG. 5, the refrigeration circuit 122 is thermally coupled to the free cooling circuit 150 via a subcooler heat exchanger 160. As shown, the subcooler heat exchanger 160 may be located directly downstream from the heat rejection heat exchanger 126 relative to the flow of refrigerant R. The subcooler heat exchanger 160 may be thermally coupled to the free cooling circuit 150, such as at a location downstream from the first heat exchanger 152 for example. Similar to the embodiment illustrated and described with reference to FIGS. 1-3, the free cooling circuit 150 may include one or more valves operable to control the flow of the free cooling fluid F within the free cooling circuit 150 to selectively thermally couple the free cooling circuit 150 to the refrigeration circuit 122. As shown, a valve V13 may be disposed along a main return conduit 162 extending between and directly fluidly connecting an outlet 153 of the first heat exchanger 152 to an inlet 157 of the second heat exchanger 154.

A free cooling bypass conduit 164 may fluidly connect the main return conduit 162 to the subcooler heat exchanger 160. As shown, an inlet of the free cooling bypass conduit 164 may be fluidly connected to the main return conduit 162 at a location downstream from the outlet 153 of the first heat exchanger 152 and upstream from the inlet 157 of the second heat exchanger 154 and the valve V13. The free cooling bypass conduit 164 may further extend from the outlet of the subcooler heat exchanger 160 to the main return conduit 162 at a location downstream from the valve V13, and upstream from the inlet 157 of the second heat exchanger 154. In an embodiment, the free cooling circuit 150 includes another valve V14, such as located downstream from the subcooler heat exchanger 160, and operable to control a flow of free cooling fluid F through the free cooling bypass conduit 164.

When valve V13 is open and valve V14 is closed, the cool free cooling fluid F output from the first heat exchanger 152 is returned directly to the second heat exchanger 154 of the free cooling circuit 150. However, when the valve V14 is at least partially open, some or all of the free cooling fluid F is provided to the first heat exchanger 152 and the subcooler heat exchanger 160 in series. As in the previous embodiment, a controller C including a processor is operable to control operation of the cooling system 120. The controller C may be operably coupled to one or more components of the cooling system 120, such as the compressor 124, pumps 146, 156, and one or more valves V11, V12, V13, V14.

The cooling system 120 is similarly operable in a first mechanical cooling mode, a second free-cooling mode, and a third combination mechanical and free-cooling mode. In the mechanical cooling mode, valve V11 may be open and valve V12 may be closed such that all of the working fluid W bypasses the second heat exchanger 154. In some embodiments, in the mechanical cooling mode, the free cooling circuit 150 may also be operational. In such embodiments, the valves of the free cooling circuit 150 may be positioned, for example valve V13 may be closed and valve V14 may be open, such that the free cooling fluid F may flow through the heat exchanger 152, the subcooler heat exchanger 160, and the second heat exchanger 154 in series. In such an embodiment, the heat exchanger 152 of the free cooling circuit 150 provides significant subcooling to the liquid refrigerant within the subcooler heat exchanger 160.

In the free-cooling mode, all cooling of the working fluid W is performed by the free cooling circuit 150. Accordingly, valve V12 is open. In the free-cooling mode, the compressor 124 may be non-operational. As a result, no heat transfer occurs between the working fluid W and the refrigerant R at the heat absorbing heat exchanger 130. Accordingly, valve V14 may be closed so that the free cooling fluid F bypasses the subcooler heat exchanger 160. In the third, mixed mechanical and free cooling mode, the working fluid W within the coolant circuit 140 is cooled at both the second heat exchanger 154 of the free cooling circuit 150 and the heat absorbing heat exchanger 130 of the refrigeration circuit 22. Accordingly, the valve V12 is open, and valve V11 may also be open. In the third mode, the free cooling fluid F may be pumped to the first heat exchanger 152, where the free cooling fluid F is cooled. From the first heat exchanger 152, the free cooling fluid F is provided to the subcooler heat exchanger 160 where the free cooling fluid F absorbs heat from the refrigerant R. The heated free cooling fluid F is then provided to the second heat exchanger 154, where the free cooling fluid F absorbs further heat from the working fluid W.

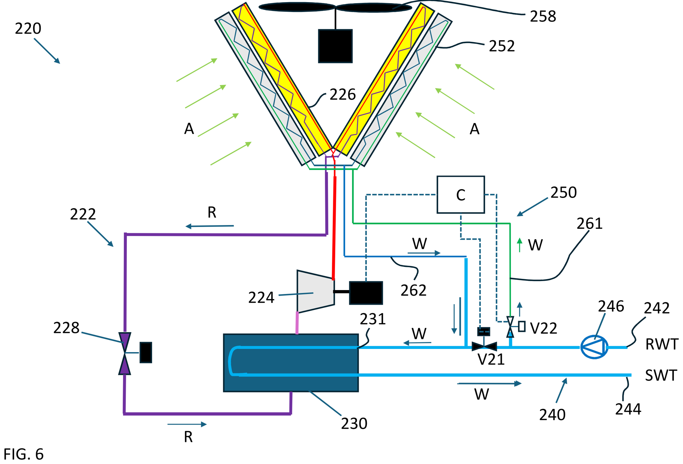

With reference now to FIGS. 6-7, another example of a cooling system 220 is illustrated. Similar to the previous embodiment, the cooling system 220 similarly includes a refrigeration circuit 222 having a closed loop configuration. In the illustrated, non-limiting embodiments, the refrigeration circuit 222 includes a compressor 224, at least one heat rejection heat exchanger or condenser 226, an expansion device 228, and at least one heat absorbing heat exchanger or evaporator 230 arranged in series relative to a flow of refrigerant.

The cooling system 220 similarly includes a coolant circuit 240 and a free cooling circuit 250. The coolant circuit 240 may be operable to cool a working fluid W to meet a cooling demand. In one or more embodiments, the coolant circuit 240 receives a hot working fluid W from an inlet 242, and provides a cooler working fluid W to an outlet 244. The coolant circuit 240 may include a pump 246 operable to circulate the working fluid W through the coolant circuit 240. In an embodiment, the working fluid W is water or a water-based fluid. In other embodiments, the working fluid of the coolant circuit 240 may include glycol or glycol-based fluids, such as ethylene glycol and/or propylene glycol.

The coolant circuit 240 may be thermally coupled to the refrigeration circuit 222. In an embodiment, the coolant circuit 240 is thermally coupled to the heat absorbing heat exchanger 230 of the refrigeration circuit 222 such that working fluid W of the coolant circuit 240 is arranged in a heat transfer arrangement with the refrigerant R of the refrigeration circuit 222 at the heat absorbing heat exchanger 230. Heat may be transferred from the working fluid W to the refrigerant R at the heat absorbing heat exchanger 230 such that the working fluid W is cooled at the heat absorbing heat exchanger 230.

The free cooling circuit 250 includes a heat exchanger 252 operable as a heat rejecting heat exchanger. As in the previous embodiments, the heat exchanger 252 may be positioned adjacent to the heat rejecting heat exchanger 226 of refrigeration circuit 222. A fan 258 or other suitable mechanism may be used to move an air flow A across both the heat exchanger 252 of the free cooling circuit 250 and the heat rejecting heat exchanger 226 of the refrigeration circuit 222 in series. The heat exchanger 252 of the free cooling circuit 250 may be located upstream from the heat rejecting heat exchanger 226 of the refrigeration circuit 222 relative to the movement of the air flow A.

As shown, the free cooling circuit 250 is fluidly connectable to the coolant circuit 240. In the illustrated, non-limiting embodiment, the free cooling circuit 250 includes a main inlet conduit 261 extending between and fluidly connecting the flow path of the coolant circuit 240 to an inlet of the free cooling heat exchanger 252. Similarly, the free cooling circuit 250 includes a main return conduit 262 extending between and fluidly connecting the outlet 253 of the free cooling heat exchanger 252 to the flow path of the coolant circuit 240. The main inlet conduit 261 may form an inlet of the free cooling circuit 250 and the main return conduit 262 may form an outlet of the free cooling circuit 250.

As shown, both the inlet and the outlet of the free cooling circuit 250 may be fluidly connected to a portion of the coolant circuit 240, such as at a location downstream from the inlet 242 and upstream from the heat absorbing heat exchanger 230. The free cooling circuit 250 may receive the working fluid W from the coolant circuit 240 and return the working fluid W to the coolant circuit 240, at the portion between the inlet 242 and the heat absorbing heat exchanger 230. Accordingly, the coolant circuit 240 includes at least one junction through which the working fluid W may be provided to the free cooling circuit 250 and at least one junction through which the working fluid W may be received from the free cooling circuit 150.

The coolant circuit 240 may include at least one valve, such as valve V21 for example, operable to control a flow of working fluid W provided directly from the inlet 242 of the coolant circuit 240 to the heat absorbing heat exchanger 230. In the illustrated, non-limiting embodiment, the inlet of the free cooling circuit 250 is fluidly connected to the coolant circuit 240 at a location upstream from the first valve V21 and the outlet of the free cooling circuit 250 is fluidly connected to the coolant circuit 240 at a location downstream from the first valve V21. However, embodiments where both the inlet and outlet of the free cooling circuit 250 are located at the same side of the first valve V21 are also contemplated herein.

The free cooling circuit 250 may alternatively or additionally include one or more valves operable to control the flow of the working fluid W therein. As shown, a valve V22 may be configured to selectively divert a working fluid from the coolant circuit 140 to the free cooling circuit 250. In the illustrated, non-limiting embodiment, the valve V22 is arranged between the inlet of the free cooling circuit 250 and the heat exchanger 252, such as directly downstream from the interface between the inlet of the free cooling circuit 250 and the coolant circuit 240.

When the first valve V21 is open and the second valve V22 is closed, as shown in FIG. 6, all of the working fluid W is directed by the pump 246 to the heat absorbing heat exchanger 230. In such a configuration, the working fluid W is not provided to or configured to circulate through the free cooling circuit 150. The working fluid W may be caused to exchange heat with the refrigerant R in the refrigeration circuit 222 at the heat absorbing heat exchanger 230. The working fluid W may then be pumped out of the heat absorbing heat exchanger 230 and exit the coolant circuit 240 via the outlet 244. In one or more embodiments, the refrigerant R may be pumped through the refrigeration circuit 222 by the compressor 224 when the first valve V21 is open and the second valve V22 is closed.

When the first valve V21 is closed and the second valve V22 is open, all of the working fluid W is directed from the pump 246 into the free cooling circuit 250. The working fluid W may be pumped through the free cooling circuit 250 by the pump 246. The working fluid W may flow through the free cooling heat exchanger 252, where the working fluid W may exchange heat with the ambient air A being blown through the free cooling heat exchanger 252 by the fan 258. For example, the working fluid W may exhaust heat to the air A. The working fluid W may then be returned to the coolant circuit 240 and circulated through the heat absorbing heat exchanger 203, before being provided to the outlet 244. In embodiments where both the first valve V21 and the second valve V22 are open, a portion of the flow of working fluid W is provided to the free cooling circuit 250 from the inlet 242 and a portion of the working fluid W from the inlet 242 bypasses the free cooling circuit 250 and is provided directly to the heat absorbing heat exchanger 230 of the refrigeration circuit 222. In instances where working fluid W from the inlet 242 is provided to the free cooling circuit 250 and working fluid W bypasses the free cooling circuit 250 in parallel, the flow of working fluid W output from the free cooling circuit 250 may be mixed with the flow of working fluid W that bypasses the free cooling circuit 250 at a location upstream from an inlet 231 of the heat absorbing heat exchanger 230 of the refrigeration circuit 222.

In an embodiment, the cooling system 220 includes a controller C. The controller C may include a processor operable to control operation of the cooling system 220. Further, as previously described, in one or more embodiments, the controller C includes a memory that may store a computer program executable by the processor, reference data, sensor data, etc. The memory may be implemented using known devices, such as random-access memory. The controller C is operably coupled to one or more components of the cooling system 220, such as the compressor 224 of the refrigeration circuit 222, the pump 246 of the coolant circuit 240, the fan 258, and/or the one or more valves V21, V22.

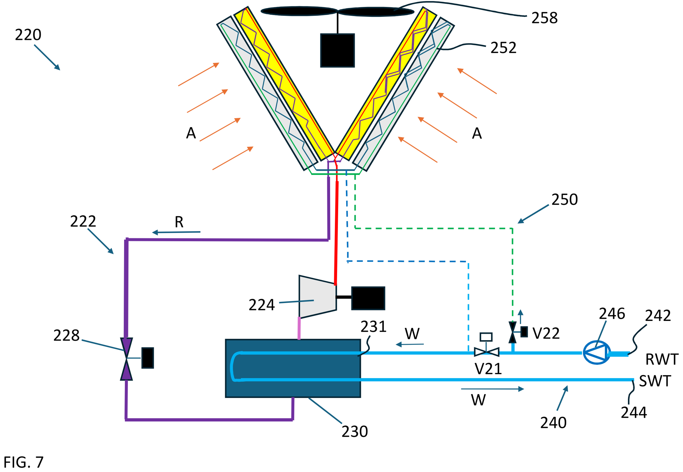

It will be appreciated that the option for free cooling via the free cooling circuit 250 and/or mechanical cooling via the refrigeration circuit 222 means that the cooling system 220 is operable in a plurality of different modes. In one or more embodiments, the cooling system 220 is operable in a first mode, a second mode, and a third mode, among others. In the first mode, shown in FIG. 7, mechanical cooling mode, the working fluid within the coolant circuit 240 is cooled solely by direct heat exchange with the refrigerant at the heat absorbing heat exchanger 230. In such embodiments, valve V21 may be open and valve V22 may be closed such that all of the working fluid flows directly from the inlet 242 to the heat absorbing heat exchanger 230, bypassing the free cooling heat exchanger 252.

In the second, free-cooling mode, as shown in FIG. 6, the working fluid W is cooled solely by heat exchange with ambient air A at the free cooling heat exchanger 252. In such embodiments, valve V21 may be closed and valve V22 may be open to direct the working fluid W from the pump 246 through the free cooling circuit 250. In the second mode, the compressor 224 of the refrigeration circuit 222 may be non-operational. As a result, no heat transfer occurs between the working fluid and the refrigerant at the heat absorbing heat exchanger 230.

In the third, mixed mechanical and free cooling mode, the working fluid within the coolant circuit 240 is cooled at both the free cooling heat exchanger 252 of the free cooling circuit 250 and the heat absorbing heat exchanger 230 of the refrigeration circuit 222. In this mode, refrigerant R is flowing within the refrigeration circuit 122. Further, the valve V21 is closed and valve V22 is opened, directing the working fluid W through the free cooling circuit 250. In the third mode, the working fluid W is first cooled by ambient air A at the free cooling heat exchanger 252. From the free cooling heat exchanger 252, the partially cooled working fluid is provided to the heat absorbing heat exchanger 230 where it is further cooled by the refrigerant R. Accordingly, in the third mode, the working fluid W is cooled by the free cooling heat exchanger 252 and the heat absorbing heat exchanger 230 in series.

It should be appreciated that the cooling system 220 may operate in one or more additional modes, such as when valve V21 is partially opened and valve V22 is fully opened. In such embodiments, a portion of the working fluid W may be diverted to the free cooling circuit 250 and another portion of the working fluid W may be provided directly to the heat absorbing heat exchanger 230. The portion of the working fluid W diverted to the free cooling circuit 250 may be cooled by the free cooling heat exchanger 252 and provided to the coolant circuit 240. The cooled portion of the working fluid W output from the free cooling heat exchanger 252 may be mixed with the portion of the working fluid W that bypasses the free cooling circuit 250. The mixed working fluid W may then be directed to the heat absorbing heat exchanger 230 for further cooling.

The controller may be configured to switch the cooling system 220 between the plurality of modes. In one or more embodiments, the controller operates the cooling system 220 in the first, mechanical cooling mode when the temperature of the ambient air surrounding the heat rejection heat exchanger 226 (also referred to herein as ambient temperature) is greater than the temperature of the working fluid at the inlet 242. In an embodiment, the cooling system 220 is operable in the free cooling mode when the temperature of the ambient air is less than the temperature of the working fluid at the inlet 242. In embodiments where free cooling via the free cooling circuit 250 is not sufficient to meet the cooling demand of the working fluid, the cooling system 220 may operate in the mixed mechanical and free cooling mode by activating the refrigeration circuit 222.

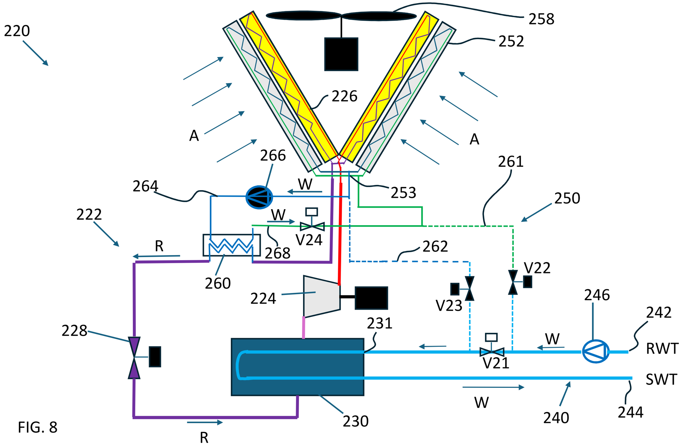

Referring now to FIGS. 8-10, the illustrated cooling system 220 is substantially similar to the cooling system of FIGS. 6 and 7. However, in the embodiment illustrated in FISG. 8 and 9, the refrigeration circuit 222 is thermally coupled to the free cooling circuit 250 via a subcooler heat exchanger 260. As shown, the subcooler heat exchanger 260 may be located directly downstream from the heat rejection heat exchanger 226 relative to the flow of refrigerant R. In an embodiment, the subcooler heat exchanger 260 is a fluid-refrigerant heat exchanger. In embodiments including a subcooler heat exchanger 260, the free cooling circuit 250 may include one or more additional valves operable to control the flow of the working fluid therein. For example, an isolation valve V23 may be arranged between the outlet 253 of the free cooling heat exchanger 252 and the outlet of the free cooling circuit 250 located at the interface between the main return conduit 262 and the coolant circuit 240.

In an embodiment, the free cooling circuit 250 is also thermally coupled to the fluid-refrigerant heat exchanger 260. The free cooling circuit 250 may additionally include at least one free cooling bypass conduit configured to circulate the working fluid W through the fluid-refrigerant subcooler heat exchanger 260 independently from the coolant circuit 240. In one or more embodiments, the free cooling circuit 250 includes a first free cooling bypass conduit 264. The first free cooling bypass conduit 264 may fluidly connect an inlet of the subcooler heat exchanger 260 to the main return conduit 262, such as at a location directly downstream from the outlet 253 of the free cooling heat exchanger 252.

A second free cooling bypass conduit 268 extending from an outlet of the subcooler heat exchanger 260 may fluidly connect the outlet of the subcooler heat exchanger 260 to the inlet of the free cooling heat exchanger 252. In one or more embodiments, the second free cooling bypass conduit 268 may fluidly connect the subcooler heat exchanger 260 with the main inlet conduit 261 at a location upstream from the inlet of the free cooling heat exchanger 252 and downstream from the second valve V22. The fluid connection between the second free cooling bypass conduit 268 and the main inlet conduit 261 may allow the working fluid W output from the subcooler heat exchanger 260 to be returned directly to the inlet of the free cooling heat exchanger 252.

In an embodiment, an auxiliary pump 266 is arranged along the flow path defined by one of the bypass conduits. Although the auxiliary pump 266 is illustrated as being arranged at the first free cooling bypass conduit 264, embodiments where the pump 266 is arranged at the second free cooling bypass conduit 268, downstream from the subcooler heat exchanger 260, are also contemplated herein. The auxiliary pump 266 may be configured to circulate the working fluid W through the free cooling circuit 250, such as through the first cooling bypass conduit 264, the subcooler heat exchanger 260, the second free cooling bypass conduit 268 and through the free cooling heat exchanger 252.

The free cooling circuit 250 may include one or more additional valves operable to control the flow of the working fluid therein. For example, an isolation valve V23 may be arranged between the outlet 253 of the free cooling heat exchanger 252 and the outlet of the free cooling circuit 250 located at the interface between the main return conduit 262 and the coolant circuit 240. In one or more embodiments, the free cooling circuit 250 may include a valve V24 associated with one the free cooling bypass conduits 264, 268. The valve V24 may be operable/configured to selectively allow the working fluid W to flow through the subcooler heat exchanger 260 and/or the free cooling bypass conduits 264, 268. In one or more embodiments, the valve V24 may be disposed on the second free cooling bypass conduit 268, downstream from an outlet of the subcooler heat exchanger 260.

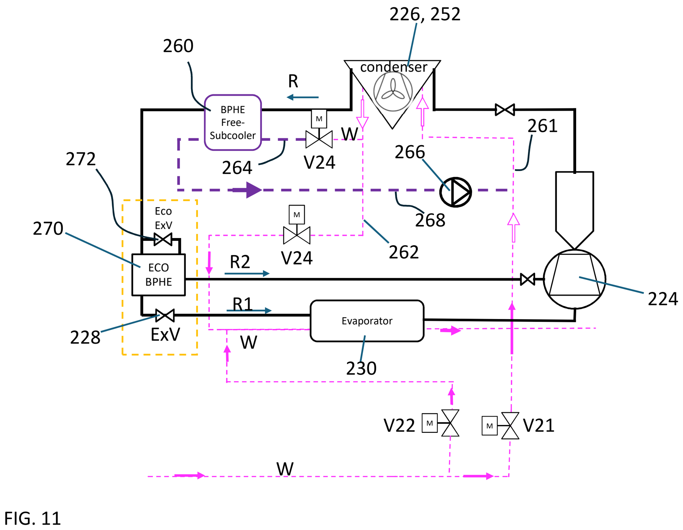

The system illustrated in FIG. 11 is substantially similar to FIGS. 8-10. However, the refrigeration circuit 222 includes an economizer heat exchanger 270, which is a refrigerant-refrigerant heat exchanger. As shown, the economizer heat exchanger 270 may be located downstream from the heat rejecting heat exchanger 226 relative to the flow of refrigerant R within the refrigeration circuit 222. As shown, two flows of refrigerant are provided to the economizer heat exchanger 270. The flow path of the refrigerant circuit may be separated directly upstream from the economizer heat exchanger 270 into a first portion of the refrigerant R1 and a second portion of the refrigerant R2, the first and second portions R1, R2 being arranged in parallel. The first portion of the refrigerant R1 flows through a first pass of the economizer heat exchanger 270. The second portion of the refrigerant R2 is provided to an economizer expansion device 272 and then to a second pass of the economizer heat exchanger 270.

Within the economizer heat exchanger 270, the second portion of the refrigerant R2 absorbs heat from the first portion of the refrigerant R1. The further cooled first portion of the refrigerant R1 is provided to the downstream expansion device 228 and the heated second portion of the refrigerant R2 output from the second pass of the economizer heat exchanger 270 is provided to an intermediate or economizer inlet of the compressor 224. As shown, the economizer heat exchanger 270 may be located downstream from the subcooler heat exchanger 260 relative to the flow of refrigerant R. Although not shown, it should be appreciated that the refrigeration system of FIGS. 6 and 7 may similarly have an economizer heat exchanger and economizer expansion device as illustrated and described herein.

As shown in FIG. 8, when valves V22 and/or V23 are closed, the free cooling circuit 250 may be fluidly isolated from the coolant circuit 240. In such embodiments, activation of the auxiliary pump 266 may circulate working fluid W within an independent loop formed by the first and the second free cooling bypass conduits 264, 268 extending between and fluidly connecting the free cooling heat exchanger 252 and the subcooler heat exchanger 260 when valve V24 is open. During operation of the refrigeration circuit R, the circulation of the fluid W through the subcooler heat exchanger 260 may act as a heat sink to absorb heat from the working fluid R, thereby cooling the refrigerant R. This reduction of the heat of the refrigerant R at the subcooler heat exchanger 260 may be in addition to, or as an alternative, to the heat rejected from the refrigerant R to the ambient air A at the heat rejecting heat exchanger 226. Further, valve V21 may be open to allow the working fluid W to circulate through the heat absorbing heat exchanger 230, thereby allowing the working fluid W in the coolant circuit 240 to reject heat to the refrigerant R.

When the valve V21 is closed and valve V22 is open, the working fluid W from the inlet 242 of the coolant circuit 240 is directed to the free cooling circuit 250. The working fluid W may flow through the main inlet conduit 261 to the free cooling heat exchanger 252. At the free cooling heat exchanger 252, the working fluid W may release heat to the ambient air A blown through or across the free cooling heat exchanger 252. In such embodiments, the valve V24 may be closed and the valve V23 may be open. With such a configuration, the working fluid W output from the free cooling heat exchanger 252 may be returned directly to the coolant circuit 240 via the main return conduit 262. The working fluid W may then be circulated through the remainder of the coolant circuit 240, such as to the heat absorbing heat exchanger 230 where the working fluid W is further cooled.

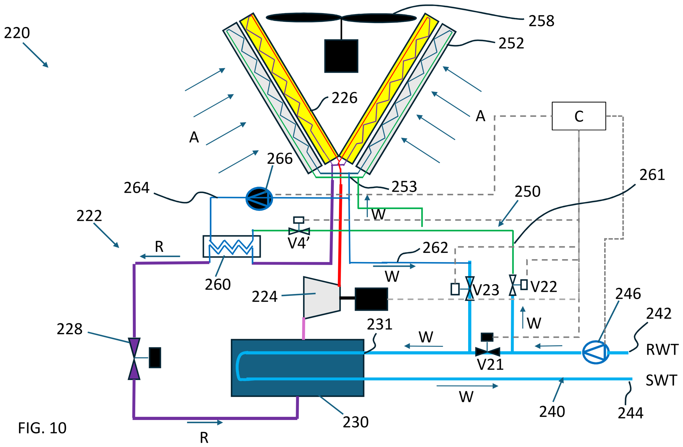

A controller may be operably coupled to one or more of the compressor 224, the pumps 246 and 266, and the valves V21-V24, as shown in FIG. 10. The controller C may adjust the operation of the components of the cooling system 220 to control a mode of operation of the cooling system 220. The cooling system 220 may be operable in a plurality of modes, including a mechanical cooling mode, a free cooling mode, and a mixed cooling mode. The cooling system 220 may operate in the first, mechanical or mixed mode, as shown in FIG. 8. In one or more embodiments, the controller C may operate the cooling system 220 in the first mode when the temperature of the ambient air A surrounding the heat exchangers 226, 252 is greater than a temperature of the working fluid W at the inlet 242 of the coolant circuit 240.

In the first mode, the free cooling circuit 250 may be fluidically isolated from the coolant circuit 240. As a result, the working fluid W within the coolant circuit 240 is cooled solely by direct heat exchange with the refrigerant R at the heat absorbing heat exchanger 230. In such embodiments, valve V21 is open, and valves V22 and V23 are closed, as shown in FIG. 8. Accordingly, working fluid W is not actively moved between the coolant circuit 240 and the free cooling circuit 250 during operation in the first mode. At the heat absorbing heat exchanger 230, the working fluid W may release heat to the refrigerant R circulating through the refrigeration circuit 222. The heated refrigerant R output from the heat absorbing heat exchanger 230 may be circulated to the heat rejecting heat exchanger 226, such as via operation of the compressor 224. The refrigerant R may release heat to the ambient air A at the heat rejecting heat exchanger 226. The refrigerant R may then be returned to the heat absorbing heat exchanger 230, after expansion at the expansion device 228. In such embodiments, no cooling of the refrigerant R may occur at the subcooler heat exchanger 260.

However, in some embodiments, during the mechanical cooling mode, the free cooling circuit 250 is operable to provide subcooling to the refrigerant R at the subcooler heat exchanger 260. For example, during operation in the first, mechanical cooling mode, valve V24 may be open, and pump 266 may be operational, such that working fluid W is circulated within a closed loop formed by the free cooling bypass conduits 264, 268 extending between and fluidly coupling the heat exchanger 252 and the subcooler heat exchanger 260. During operation of the refrigeration circuit R, the circulation of the fluid W through the subcooler heat exchanger 260 may act as a heat sink to absorb heat from the working fluid R, thereby cooling the refrigerant R. This reduction of the heat of the refrigerant R at the subcooler heat exchanger 260 may be in addition to, or as an alternative, to the heat rejected from the refrigerant R to the ambient air A at the heat rejecting heat exchanger 226. Further, valve V21 may be open to allow the working fluid W to circulate through the heat absorbing heat exchanger 230, thereby allowing the working fluid W in the coolant circuit 240 to reject heat to the refrigerant R.

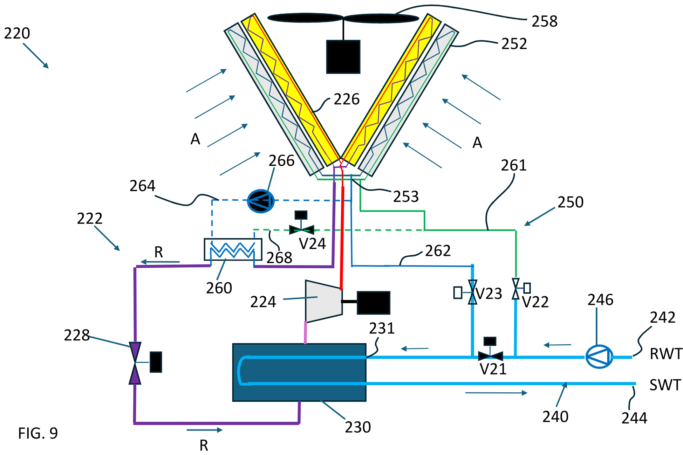

The controller C may operate the cooling system 220 in the second, free cooling mode when the temperature of the ambient air A is less than the temperature of the working fluid at the inlet 242. With reference to FIG. 9, in the second mode, the controller C may close the valve V21 and open the valves V22 and V23, thereby directing the working fluid W from the coolant circuit 240 towards the free cooling circuit 250. The working fluid W may be directed through the main inlet conduit 261 to the heat exchanger 252, where the working fluid W is cooled or pre-cooled. In embodiments where valve V24 is closed and valve V23 is open, the working fluid W output from the free cooling heat exchanger 252 may be returned directly to the coolant circuit 240 via the main return conduit 262. The working fluid W may then be circulated through the remainder of the coolant circuit 240.

In the second mode, the refrigeration circuit 222 is non-operational. As a result, no heat transfer occurs between the working fluid W and the refrigerant R at either the subcooler heat exchanger 260 or the heat absorbing heat exchanger 230. Although the working fluid W may be provided to the heat absorbing heat exchanger 230 during operation in the second mode, no heat transfer takes place therein. However, in the third, mixed mechanical and free cooling mode, the working fluid W is cooled by both the heat exchanger 252 of the free cooling circuit 250 and the heat absorbing heat exchanger 230 of the refrigeration circuit 222. In the third mode, refrigerant R is circulating in the refrigeration circuit 222 and the working fluid W is provided from the coolant circuit 240 to the free cooling circuit 250. As shown in FIG. 10, valve V21 is closed and valves V22, V23, and V24 are open. As a result, the working fluid W is circulated from the coolant circuit 240 to the heat exchanger 252. After being cooled via the ambient air A at the heat exchanger 252, the working fluid W is pumped via that auxiliary pump 266 to the subcooler heat exchanger 260 where the working fluid W absorbs heat from the refrigerant R. The heated working fluid W is then returned to the coolant circuit 240 and provided to the heat absorbing heat exchanger 230, where the working fluid W exhausts heat to the refrigerant R. In embodiments where free cooling of the working fluid W via the heat exchanger 252 is not sufficient to meet the cooling demand of working fluid W, mechanical cooling may be used alternatively to or in addition to the free cooling by activating the refrigeration circuit 222.

Although not shown, in one or more embodiments, the controller C may be configured to receive temperature data from temperature sensors. In one or more embodiments, at least one temperature sensor may be disposed at the coolant circuits 40, 140, 240. In one or more embodiments, a temperature sensor may be disposed or in proximity to inlet 42, 142, 242 of the coolant circuits 40, 140, 240, respectively. Further, another temperature sensor may be configured to determine the temperature of the ambient air A. The another temperature sensor may be disposed upstream of the first heat exchanger 52, 152, 252.

A method of operating a cooling system comprising includes providing a coolant circuit for cooling a working fluid to meet a cooling demand, a refrigeration circuit selectively thermally coupled to the coolant circuit, and a free cooling circuit selectively thermally coupled to at least one of the coolant circuit and the refrigeration circuit. The method further includes directly transferring heat from the refrigeration circuit to the free cooling circuit during at least one mode of operation of the cooling system. During the method of operating of the cooling system, the refrigeration circuit is used to cool the working fluid when an ambient temperature is greater than a temperature of the working fluid at an inlet of the coolant circuit and/or the free cooling circuit is used to cool the working fluid when the ambient temperature is less than the temperature of the working fluid at the inlet of the coolant circuit. The method of operating of the cooling system further includes, one or more of bypassing an interface between the coolant circuit and the free cooling circuit when the refrigeration circuit is operational, moving the working fluid between the coolant circuit and the free cooling circuit in series when the refrigeration circuit is operational, and cooling a fluid of the free cooling circuit directly upstream from a thermal interface between the refrigeration circuit and the free cooling circuit.

A cooling system 20, 120, 220 where the fluid within the free cooling circuit 50, 50' is used to sub-cool the refrigerant R within the refrigeration circuit 33 has an increased capacity and efficiency.

The term "about" is intended to include the degree of error associated with measurement of the particular quantity based upon the equipment available at the time of filing the application.

The terminology used herein is for the purpose of describing particular embodiments only and is not intended to be limiting of the present invention. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present invention has been described with reference to an exemplary embodiment or embodiments, it will be understood by those skilled in the art that various changes may be made and equivalents may be substituted for elements thereof without departing from the scope of the present invention as defined by the appended claims. In addition, many modifications may be made to adapt a particular situation or material to the teachings of the present invention without departing from the scope thereof as defined by the appended claims. Therefore, it is intended that the present invention not be limited to the particular embodiment disclosed as the best mode contemplated for carrying out this present invention, but that the present invention will include all embodiments falling within the scope of the claims.

The following clauses set out features of the invention which may or may not presently be claimed in this application, but which may form the basis for future amendment or a divisional application.
1. A cooling system comprising: a refrigeration circuit; a coolant circuit for cooling a working fluid to meet a cooling demand, the coolant circuit being thermally coupled to the refrigeration circuit; and a free cooling circuit in selective thermal communication with the refrigeration circuit and in selective thermal communication with the coolant circuit.
2. The cooling system of clause 1, wherein the refrigeration circuit includes a heat rejection heat exchanger and the free cooling circuit includes a first heat exchanger positioned directly adjacent to the heat rejection heat exchanger.
3. The cooling system of clause 2, further comprising a fan operable to move a flow of air across the first heat exchanger and the heat rejection heat exchanger in series, the first heat exchanger being upstream from the heat rejection heat exchanger relative to the flow of air.
4. The cooling system of clause 2, wherein the free cooling circuit includes a subcooler heat exchanger and the free cooling circuit is thermally coupled to the refrigeration circuit at the subcooler heat exchanger.
5. The cooling system of any of clause 4, wherein the first heat exchanger and the subcooler heat exchanger are arranged in series relative to a flow of free cooling fluid within the free cooling circuit.
6. The cooling system of clause 4, wherein the subcooler heat exchanger is arranged downstream from the heat rejection heat exchanger relative to a flow of refrigerant circulating through the refrigeration circuit.
7. The cooling system of clause 4, wherein the free cooling circuit includes a main return conduit and a first free cooling bypass conduit arranged in parallel, the first free cooling bypass conduit being fluidly connected to an inlet of the subcooler heat exchanger.
8. The cooling system of clause 7, further comprising: a second free cooling bypass conduit fluidly connecting an outlet of the subcooler heat exchanger to the main return conduit; a valve disposed within the main return conduit; and another valve disposed within the second free cooling bypass conduit.
9. The cooling system of clause 8, wherein the inlet of the first free cooling bypass conduit is fluidly connected to the main return conduit upstream from the valve and the outlet of the second free cooling bypass conduit is fluidly connected to the main return conduit downstream from the valve.
10. The cooling system of clause 1, wherein the free cooling circuit includes a second heat exchanger, the free cooling circuit being thermally coupled to the coolant circuit at the second heat exchanger.
11. A cooling system comprising: a refrigeration circuit; a coolant circuit thermally coupled to the refrigeration circuit; and a free cooling circuit in selective fluid communication with the coolant circuit and in selective thermal communication with the refrigeration circuit.
12. The cooling system of clause 11, wherein the refrigeration circuit includes a heat absorbing heat exchanger, the coolant circuit being thermally coupled the refrigeration circuit at the heat absorbing heat exchanger.
13. The cooling system of clause 12, wherein both an inlet of the free cooling circuit and an outlet of the free cooling circuit are fluidly connected to the coolant circuit upstream from the heat absorbing heat exchanger.
14. The cooling system of clause 13, further comprising at least one valve operable to control a flow of fluid from the coolant circuit to the free cooling circuit.
15. The cooling system of clause 11, wherein the refrigeration circuit includes a heat rejecting heat exchanger and the free cooling circuit includes a first heat exchanger positioned directly adjacent to the heat rejecting heat exchanger, the first heat exchanger being arranged in series with the heat rejecting heat exchanger relative to an air flow.
16. The cooling system of clause 15, wherein the free cooling circuit includes a subcooler heat exchanger, the free cooling circuit being thermally coupled the refrigeration circuit at the subcooler heat exchanger, wherein the first heat exchanger and the subcooler heat exchanger are arranged in series relative to a flow of fluid within the free cooling circuit.
17. The cooling system of clause 16, wherein the free cooling circuit further comprises a first free cooling bypass conduit extending between and fluidly connecting an outlet of the first heat exchanger and an inlet of the subcooler heat exchanger.
18. The cooling system of clause 17, wherein the free cooling circuit further comprises a second free cooling bypass conduit extending between and fluidly connecting an outlet of the subcooler heat exchanger and an inlet of the first heat exchanger.
19. The cooling system of clause 18, wherein the free cooling circuit further comprises at least one valve operable to fluidly separate the free cooling circuit from the coolant circuit, wherein when the free cooling circuit is fluidly separate from the coolant circuit, the flow of fluid at the outlet of the subcooler heat exchanger is returned directly to the inlet of the first heat exchanger via the second free cooling bypass conduit.
20. The cooling system of clause 18, wherein the free cooling circuit further comprises an auxiliary pump to circulate the fluid between the first heat exchanger and the subcooler heat exchanger.

## Claims

1. A cooling system (20) comprising:
a refrigeration circuit (22);
a coolant circuit (40) for cooling a working fluid to meet a cooling demand, the coolant circuit being thermally coupled to the refrigeration circuit; and
a free cooling circuit (50) in selective thermal communication with the refrigeration circuit and in selective thermal communication with the coolant circuit.

2. The cooling system (20) of claim 1, wherein the refrigeration circuit (22) includes a heat rejection heat exchanger (26) and the free cooling circuit includes a first heat exchanger (52) positioned directly adjacent to the heat rejection heat exchanger, and
optionally wherein the cooling system further comprises a fan (58) operable to move a flow of air across the first heat exchanger (52) and the heat rejection heat exchanger (26) in series, the first heat exchanger being upstream from the heat rejection heat exchanger relative to the flow of air.

3. The cooling system (20) of claim 2, wherein the free cooling circuit (50) includes a subcooler heat exchanger (60) and the free cooling circuit is thermally coupled to the refrigeration circuit (22) at the subcooler heat exchanger.

4. The cooling system (20) of claim 3, wherein the first heat exchanger (52) and the subcooler heat exchanger (60) are arranged in series relative to a flow of free cooling fluid within the free cooling circuit (50), and/or
wherein the subcooler heat exchanger (60) is arranged downstream from the heat rejection heat exchanger (26) relative to a flow of refrigerant circulating through the refrigeration circuit.

5. The cooling system (20) of claim 3 or 4, wherein the free cooling circuit (50) includes a main return conduit (62) and a first free cooling bypass conduit (64) arranged in parallel, the first free cooling bypass conduit being fluidly connected to an inlet of the subcooler heat exchanger (60).

6. The cooling system (20) of claim 5, further comprising:
a second free cooling bypass conduit (68) fluidly connecting an outlet of the subcooler heat exchanger (60) to the main return conduit (62);
a valve disposed within the main return conduit; and
another valve disposed within the second free cooling bypass conduit,
optionally, wherein the inlet of the first free cooling bypass conduit (64) is fluidly connected to the main return conduit (62) upstream from the valve and the outlet of the second free cooling bypass conduit (68) is fluidly connected to the main return conduit downstream from the valve.

7. The cooling system (20) of any preceding claim, wherein the free cooling circuit (50) includes a second heat exchanger (54), the free cooling circuit being thermally coupled to the coolant circuit (40) at the second heat exchanger.

8. A cooling system (220) comprising:
a refrigeration circuit (222);
a coolant circuit (240) thermally coupled to the refrigeration circuit; and
a free cooling circuit (250) in selective fluid communication with the coolant circuit and in selective thermal communication with the refrigeration circuit.

9. The cooling system (220) of claim 8, wherein the refrigeration circuit (222) includes a heat absorbing heat exchanger (230), the coolant circuit (240) being thermally coupled the refrigeration circuit at the heat absorbing heat exchanger.

10. The cooling system (220) of claim 9, wherein both an inlet of the free cooling circuit (250) and an outlet of the free cooling circuit are fluidly connected to the coolant circuit (240) upstream from the heat absorbing heat exchanger (230), and
optionally wherein the cooling system (220) further comprises at least one valve operable to control a flow of fluid from the coolant circuit (240) to the free cooling circuit (250).

11. The cooling system (220) of claims 8, 9 or 10, wherein the refrigeration circuit (222) includes a heat rejecting heat exchanger (226) and the free cooling circuit (250) includes a first heat exchanger (252) positioned directly adjacent to the heat rejecting heat exchanger, the first heat exchanger being arranged in series with the heat rejecting heat exchanger relative to an air flow.

12. The cooling system (220) of claim 11, wherein the free cooling circuit (250) includes a subcooler heat exchanger (260), the free cooling circuit being thermally coupled the refrigeration circuit at the subcooler heat exchanger, wherein the first heat exchanger (252) and the subcooler heat exchanger are arranged in series relative to a flow of fluid within the free cooling circuit.

13. The cooling system (220) of claim 12, wherein the free cooling circuit (250) further comprises a first free cooling bypass conduit (264) extending between and fluidly connecting an outlet of the first heat exchanger (252) and an inlet of the subcooler heat exchanger (260).

14. The cooling system (220) of claim 13, wherein the free cooling circuit (250) further comprises a second free cooling bypass conduit (268) extending between and fluidly connecting an outlet of the subcooler heat exchanger (260) and an inlet of the first heat exchanger (252).

15. The cooling system (220) of claim 14, wherein the free cooling circuit (250) further comprises at least one valve operable to fluidly separate the free cooling circuit from the coolant circuit (240), wherein when the free cooling circuit is fluidly separate from the coolant circuit, the flow of fluid at the outlet of the subcooler heat exchanger (260) is returned directly to the inlet of the first heat exchanger (252) via the second free cooling bypass conduit (268), and/or
wherein the free cooling circuit (250) further comprises an auxiliary pump (266) to circulate the fluid between the first heat exchanger (252) and the subcooler heat exchanger (260).
